# EUROPÄISCHE PATENTANMELDUNG

(11) **EP 3 522 375 A1**
(43) Veröffentlichungstag der Anmeldung: **07.08.2019**
(21) Anmeldenummer: 18155381.9
(22) Anmeldetag: 06.02.2018
(51) Int. Cl.: H03K 17/082, H03K 17/18

(54) **VERFAHREN ZUM STEUERN EINER LEISTUNGSELEKTRONISCHEN SCHALTUNG, PROGRAMM ZUR DURCHFÜHRUNG DIESES VERFAHRENS UND LEISTUNGSELEKTRONISCHE SCHALTUNG**

(71) Anmelder: Siemens Aktiengesellschaft, 80333 München (DE)
(72) Erfinder: BLANK, Rene, 12249 Berlin (DE); FRANKE, Martin, 14089 Berlin (DE); FRÜHAUF, Peter, 14612 Falkensee (DE); HEIMANN, Matthias, 14469 Potsdam (DE); JESKE, Nora, 10555 Berlin (DE); KNOFE, Rüdiger, 14513 Teltow (DE); MEYRATH, Wilhelm, 3400 Klosterneuburg (AT); MÜLLER, Bernd, 16259 Falkenberg (DE); NERRETER, Stefan, 15754 Heidesee OT Blossin (DE); PFLEGER, Franz, 1030 Wien (AT); PRANKH, Peter, 2301 Groß-Enzersdorf (AT); STROGIES, Jörg, 14163 Berlin (DE)

(57) **Zusammenfassung**

Die Erfindung betrifft ein Verfahren zum Steuern einer leistungselektronischen Schaltung mit einer Vielzahl von Leistungsmodulen (11). Es ist vorgesehen, dass jedes Leistungsmodul eine eigene Treiberschaltung (49) aufweist, mit der dieses angesteuert werden kann. Von jedem Leistungsmodul wird mit einem eigenen Sensorelement (25a) eine Zustandsgröße erfasst. Die Treiberschaltung wird über einen Prozessor (P) gesteuert, wobei der Prozessor aus der Zustandsgröße des Sensors (25a) Zustandsdaten berechnet, die für die Steuerung der Treiberschaltung (49) relevant ist. Auf diese Weise kann vorteilhaft mit dem Prozessor (P) ein modularer Aufbau einer Leistungsschaltung, die aus mehreren Modulen (11) besteht, betrieben werden. Gegenstand der Erfindung ist auch eine leistungselektronische Schaltung, die das beschriebene Betriebsverfahren ermöglicht sowie ein Computerprogrammprodukt mit Programmbefehlen für die Durchführung des Verfahrens und eine Bereitstellungsvorrichtung für ein solches Computerprogrammprodukt.

## Beschreibung

Die Erfindung betrifft ein Verfahren zum Steuern einer leistungselektronischen Schaltung, bei der eine Vielzahl von Leistungsmodulen, die jeweils mindestens ein leistungselektronisches Bauelement aufweisen, angesteuert wird. Außerdem betrifft die Erfindung ein Computerprogrammprodukt mit Programmbefehlen zur Durchführung dieses Verfahrens bzw. eine Bereitstellungsvorrichtung für dieses Computerprogrammprodukt. Zuletzt betrifft die Erfindung eine leistungselektronische Schaltung mit einer Vielzahl von Leistungsmodulen, wobei jedes Leistungsmodul mindestens ein leistungselektronisches Bauelement aufweist.

Leistungselektronische Schaltungen sind üblicherweise auf einen zugehörigen gegebenen Anwendungsfall anzupassen. Diese Anwendungsfälle unterscheiden sich individuell, wodurch bei der Auslegung der leistungselektronischen Schaltungen und bei deren Herstellung ein beträchtlicher Aufwand entsteht. Die individuellen Anwendungsfälle stehen insbesondere einer Automatisierbarkeit der Herstellung von Leistungsmodulen im Wege.

Die Verwendung leistungselektronischer Schaltungen für unterschiedliche Anwendungsfälle erfordert außerdem eine Ansteuerung der leistungselektronischen Schaltung unter Berücksichtigung des jeweiligen Anwendungsfalls. Daher muss das Steuerverfahren für die leistungselektronische Schaltung die Besonderheiten des jeweiligen Anwendungsfalls berücksichtigen. Dabei sind die Vorgaben des Anwendungsfalls zu berücksichtigen, beispielsweise die Eingangs- und Ausgangsgrößen, die erforderliche Funktionszuverlässigkeit (Ausfallsicherheit) usw.

Die Aufgabe der Erfindung besteht darin, ein Verfahren zum Steuern einer leistungselektronischen Schaltung anzugeben, welches sich einfach an unterschiedliche Anwendungsfälle für die leistungselektronische Schaltung anpassen lässt. Weiterhin ist es Aufgabe der Erfindung, eine leistungselektronische Schaltung anzugeben, welche bessere Möglichkeiten eröffnet, durch ein Steuerverfahren auf unterschiedliche Anwendungsfälle angepasst zu werden. Zuletzt ist es Aufgabe der Erfindung, ein Computerprogrammprodukt bzw. eine Bereitstellungsvorrichtung für das Computerprogrammprodukt anzugeben, mit dem sich das oben genannte Verfahren durchführen lässt.

Die erstgenannte Aufgabe wird mit dem eingangs angegebenen Verfahren erfindungsgemäß dadurch gelöst, dass jedes Leistungsmodul mit einer eigenen Treiberschaltung separat angesteuert wird. Die Treiberschaltung bildet somit einen Prozessor, der die Funktion des Leistungsmoduls sicherstellt. Insbesondere werden mit der Treiberschaltung die in dem Leistungsmodul notwendigen Schaltvorgänge ausgelöst. Außerdem wird erfindungsgemäß von jedem Leistungsmodul mit einem eigenen Sensorelement, d. h. mit einem Sensorelement, welches dem jeweiligen Leistungsmodul zugeordnet ist, zumindest eine Zustandsgröße erfasst. Mit einem Prozessor, der aus dieser Zustandsgröße Zustandsdaten berechnet, wird dann die Treiberschaltung jedes Leistungsmoduls in Abhängigkeit von den Zustandsdaten gesteuert.

Während die Treiberschaltung also für die direkte Ansteuerung der Leistungsmodule verantwortlich ist, also die Funktion der leistungselektronischen Bauelemente kontrolliert (beispielsweise das Durchführen von Schaltvorgängen durch die leistungselektronischen Bauelemente), ist der Prozessor für die Steuerung der Treiberschaltungen mehrerer Leistungsmodule oder der Treiberschaltung eines bestimmten Leistungsmoduls verantwortlich und steuert damit die übergeordnete Funktion des Leistungsmoduls, also beispielsweise, wann das Leistungsmodul arbeiten soll. Zu diesem Zweck ist üblicherweise auf dem Prozessor ein Programm zur Verarbeitung der Sensorsignale und zur Ausgabe von Steuersignalen für die Treiberschaltung installiert. Der Prozessor ist dabei mindestens einem Leistungsmodul zugeordnet, derart, dass eine erste Schnittstelle für Sensorsignale zu mindestens einem Sensorelement des Leistungsmoduls und eine zweite Schnittstelle für Steuersignale zu der Treiberschaltung des Leistungsmoduls vorhanden ist.

Der modulare Aufbau der Steuerung orientiert sich vorteilhaft an dem modularen Aufbau der Leistungsmodule. Dadurch kann vorteilhaft eine flexible Anpassung der Funktionsweise der Leistungsmodule an einen bestimmten Anwendungsfall durchgeführt werden. Diese Anpassung kann vorteilhaft durch die auf dem Prozessor installierte Software erfolgen, ohne die Konfiguration der Treiberschaltung für das Leistungsmodul zu verändern. Die Leistungsmodule können daher vorteilhaft zu verschiedenen leistungselektronischen Schaltungen kombiniert werden, wobei die Funktionsweise der leistungselektronischen Schaltung durch das auf dem Prozessor installierte Programm bzw. durch die auf den Prozessoren installierten Programme definiert wird.

Ein weiterer Vorteil des erfindungsgemäßen Verfahrens liegt darin, dass jedes Leistungsmodul ein eigenes Sensorelement aufweist. Hierdurch kann trotz freier Konfigurierbarkeit der leistungselektronischen Schaltung durch Kombination der Leistungsmodule eine zuverlässige Überwachung der leistungselektronischen Schaltung erfolgen, was deren Funktionsweise sicherstellt. Dabei werden die Leistungsmodule hinsichtlich mindestens einer Zustandsgröße überwacht, wobei der Prozessor oder die Prozessoren diejenigen Zustandsdaten berechnen, die bei der Steuerung der Treiberschaltungen berücksichtigt werden. Auch hier ist es möglich, dass eine Konfiguration der leistungselektronischen Schaltung mit einer Vielzahl von Leistungsmodulen mit geeigneten Programmen auf dem Prozessor oder den Prozessoren ausgestattet wird, damit die leistungselektronische Schaltung für den intendierten Anwendungsfall zuverlässig gesteuert werden kann.

Sofern es in der dieser Beschreibung nicht anders angegeben ist, beziehen sich die Begriffe "erstellen", "berechnen", "rechnen", "feststellen", "generieren", "konfigurieren", "modifizieren" und dergleichen, vorzugsweise auf Handlungen und/oder Prozesse und/oder Verarbeitungsschritte, die Daten verändern und/oder erzeugen und/oder die Daten in andere Daten überführen, wobei die Daten insbesondere als physikalische Größen dargestellt werden oder vorliegen können, beispielsweise als elektrische Impulse.

Unter "rechnergestützt" kann im Zusammenhang mit der Erfindung beispielsweise eine Implementierung des Verfahrens verstanden werden, bei dem ein Computer oder mehrere Computer mindestens einen Verfahrensschritt des Verfahrens ausführt oder ausführen.

Unter einem "Prozessor" kann im Zusammenhang mit der Erfindung beispielsweise eine Maschine oder eine elektronische Schaltung verstanden werden. Bei einem Prozessor kann es sich insbesondere um einen Hauptprozessor (engl. Central Processing Unit, CPU), einen Mikroprozessor oder einen Mikrokontroller, beispielsweise eine anwendungsspezifische integrierte Schaltung oder einen digitalen Signalprozessor, möglicherweise in Kombination mit einer Speichereinheit zum Speichern von Programmbefehlen, etc. handeln. Bei einem Prozessor kann es sich beispielsweise auch um einen IC (integrierter Schaltkreis, engl. Integrated Circuit), insbesondere einen FPGA (engl. Field Programmable Gate Array) oder einen ASIC (anwendungsspezifische integrierte Schaltung, engl. Application-Specific Integrated Circuit), oder einen DSP (Digitaler Signalprozessor, engl. Digital Signal Processor) handeln. Auch kann unter einem Prozessor ein virtualisierter Prozessor oder eine Soft-CPU verstanden werden. Es kann sich beispielsweise auch um einen programmierbaren Prozessor handeln, der mit einer Konfiguration zur Ausführung des genannten erfindungsgemäßen Verfahrens ausgerüstet ist.

Unter einer "Speichereinheit" kann im Zusammenhang mit der Erfindung beispielsweise ein computerlesbarer Speicher in Form eines Arbeitsspeichers (engl. Random-Access Memory, RAM) oder einer Festplatte verstanden werden.

Es ist möglich, dass der oben erwähnte Prozessor für mehrere Leistungsmodule vorgesehen ist, also die Zustandsgrößen mehrerer Leistungsmodule auswertet, d. h. Zustandsdaten berechnet, und jedes dieser Leistungsmodule in Abhängigkeit von diesen Zustandsdaten steuert. Gemäß einer besonderen Ausgestaltung der Erfindung ist jedoch vorgesehen, dass jedes Leistungsmodul einen eigenen Prozessor aufweist, mit dem nur die Treiberschaltung dieses Leistungsmoduls in Abhängigkeit von den Zustandsdaten gesteuert wird. Dies ermöglicht vorteilhaft die Verwendung von Leistungsmodulen, die ein gewisses Maß an Steuerintelligenz enthalten und daher vorteilhaft mit geringem Aufwand zu leistungselektronischen Schaltungen kombiniert werden können. Beispielsweise kann auf den Prozessoren jedes Leistungsmoduls ein Programm installiert sein, welches grundlegende Funktionen des Leistungsmoduls steuert, wie z. B. einen Überlastungsschutz, der das Leistungsmodul vor Beschädigungen schützt.

Gemäß einer weiteren Ausgestaltung der Erfindung ist vorgesehen, dass bei Verwendung von Prozessoren der Leistungsmodule, die also je einem Leistungsmodul direkt zugeordnet sind, die leistungselektronische Schaltung zusätzlich einen zentralen Prozessor aufweist, der mit den Prozessoren der Leistungsmodule kommuniziert. Die Kommunikation erfolgt derart, dass die Prozessoren der Leistungsmodule Zustandsdaten der Leistungsmodule an den zentralen Prozessor übergeben und der zentrale Prozessor Steuersignale für die Leistungsmodule an die Prozessoren der Leistungsmodule übergibt. Die Kommunikation zwischen den Prozessoren der Leistungsmodule und dem zentralen Prozessor wird über eine dritte Schnittstelle sichergestellt. Diese dritte Schnittstelle kann aus mehreren Signalverbindungen oder auch einer gemeinsamen Signalverbindung (beispielsweise einen BUS) bestehen.

Die Kombination der Prozessoren der Leistungsmodule mit einem zentralen Prozessor hat den Vorteil, dass über den zentralen Prozessor ein übergeordnetes Betriebsregime für die leistungselektronische Schaltung, bestehend aus den einzelnen Leistungsmodulen, umgesetzt werden kann. Die Prozessoren der Leistungsmodule können dann vorteilhaft die Grundfunktionen der Leistungsmodule sicherstellen und müssen nicht notwendigerweise für jeden Anwendungsfall neu programmiert werden. Gleichzeitig können die Prozessoren der Leistungsmodule eine gewisse Intelligenz beim Betrieb dieser Leistungsmodule sicherstellen.

Der zentrale Prozessor weist ein übergeordnetes Steuerprogramm auf, welches den Anwendungsfall der leistungselektronischen Schaltung berücksichtigt. Dieses kann für einen bestimmten Anwendungsfall programmiert werden oder stellt konfigurierbare Betriebsparameter zur Verfügung, welche eine Modifikation des Betriebsregimes der leistungselektronischen Schaltung in bestimmten Parameterbereichen erlaubt. Hierdurch ist es vorteilhaft möglich, leistungselektronische Schaltungen herzustellen, welche mit einem vorteilhaft geringen Aufwand an den gegebenen Anwendungsfall angepasst werden können. Dabei können vorgefertigte Leistungsmodule zum Einsatz kommen, die in großer Stückzahl gefertigt werden können und daher kostengünstig in der Herstellung sind.

Gemäß einer weiteren Ausgestaltung der Erfindung ist vorgesehen, dass die Zustandsdaten der Leistungsmodule einen berechneten Belastungszustand des jeweiligen Leistungsmoduls enthalten. Hierbei handelt es sich um ein wichtiges Kriterium für den Betrieb der Leistungsmodule. Diese können nämlich rechtzeitig abgeschaltet werden, wenn eine Überlastung droht, so dass ein Versagen der Leistungsmodule oder im schlimmsten Fall eine Beschädigung oder Zerstörung verhindert werden kann. Dabei kann die Berechnung des Belastungszustands (Zustandsdaten) sowohl in den Prozessoren der Leistungsmodule (also den direkt einem Leistungsmodul zugeordneten Prozessoren) oder den zentralen Prozessor (den für alle betrachteten Leistungsmodule zuständigen Prozessor) durchgeführt werden. Auch in einem Prozessor, der mehreren nicht mit einzelnen Prozessoren ausgestatteten Leistungsmodulen zugeordnet ist, kann eine solche Berechnung erfolgen.

Eine andere Ausgestaltung der Erfindung sieht vor, dass Zustandsdaten der Leistungsmodule in mindestens einer Speichereinheit gespeichert werden. Die Speichereinheit ist üblicherweise in den Prozessor integriert, kann jedoch auch aus einem gesonderten Baustein bestehen. Die Speicherung der Zustandsdaten ist von Vorteil, da hierdurch eine Veränderung der Leistungsmodule während des Betriebs durch Vergleich der Zustandsdaten ermittelt werden kann. Hierbei können Aspekte wie einer Alterung bzw. Verschleiß der Leistungsmodule oder Qualitätsprobleme aufgedeckt werden.

Aus einer Alterung der Leistungsmodule können beispielsweise Wartungsintervalle oder auch die Notwendigkeit eines Austauschs eines Leistungsmoduls abgeleitet werden. Hierdurch ist eine Wartung bzw. Reparatur der leistungselektronischen Schaltung möglich, bevor diese aufgrund eines Fehlers ausfällt. Dies hilft dabei, Stillstandzeiten aufgrund eines Ausfalls der leistungselektronischen Schaltung zu vermeiden, was sich positiv auf die Wirtschaftlichkeit des Betriebs der leistungselektronischen Schaltung auswirkt.

Besonders vorteilhaft ist es, jedem der Prozessoren der Leistungsmodule jeweils eine Speichereinheit für die Zustandsdaten zuzuordnen. Hierdurch können die Zustandsdaten des jeweiligen Leistungsmoduls nicht nur individuell für jedes Leistungsmodul berechnet werden, sondern auch individuell für jedes Leistungsmodul abgespeichert werden. Das Leistungsmodul kann daher vorteilhaft bestimmte Aufgaben selbständig übernehmen und z. B. auch ein Signal an einen zentralen Prozessor weitergeben, welches wesentliche Informationen über die Funktionsfähigkeit des Leistungsmoduls enthält.

Weiterhin ist es vorteilhaft, wenn eine Speichereinheit für die Zustandsdaten dem zentralen Prozessor zugeordnet ist. Diese Speichereinheit kann zusätzlich zu Speichereinheiten vorgesehen werden, die den einzelnen Prozessoren zugeordnet sind oder als zentrale Speichereinheit für alle Zustandsdaten, also auch den individuell in den Leistungsmodulen berechneten, dienen. In jedem Fall ist es möglich, in der Speichereinheit des zentralen Prozessors übergeordnete Funktionen der aus den Leistungsmodulen zusammengesetzten leistungselektronischen Schaltung abzuspeichern. Diese übergeordneten Daten können beispielsweise eine prozentuale Auslastung des Leistungsmoduls oder das Abschalten einzelner Leistungsmodule und damit die Verfügbarkeit der abrufbaren Leistung des Leistungsmoduls beinhalten.

Wenn sowohl Prozessoren der Leistungsmodule als auch ein zentraler Prozessor vorgesehen sind, ergibt sich eine vorteilhafte Ausgestaltung der Erfindung dadurch, dass die Prozessoren der Leistungsmodule die Zustandsdaten bewerten und nur eine Auswahl von Zustandsdaten an den zentralen Prozessor weitergeben. Hierdurch lässt sich eine Datenverdichtung erreichen, welche vorteilhaft dazu führt, dass der zentrale Prozessor schneller mit den ihm zur Verfügung gestellten Daten rechnen kann. Vorteilhaft kann dadurch beispielsweise auf Änderungen des Betriebszustands schneller durch Steuersignale für die leistungselektronische Schaltung reagiert werden, wobei diese Steuersignale durch den zentralen Prozessor ausgegeben werden. Die Prozessoren der Leistungsmodule gewährleisten dabei sozusagen eine gewisse Intelligenz der Leistungsmodule, und steuern Betriebsparameter unabhängig von dem zentralen Prozessor, soweit diese eine übergeordnete Priorität haben. Dies kann beispielweise ein Abschalten von Leistungsmodulen sein, die aufgrund einer Überlastung sonst zerstört würden.

Die dritte Schnittstelle zwischen den Prozessoren der Leistungsmodule und dem zentralen Prozessor kann jedoch auch genutzt werden, um beim Datenaustausch bestimmte Steuersignale zu gewichten. Wenn beispielsweise das Betriebsregime der leistungselektronischen Schaltung eine Leistungsabgabe in jedem Fall erfordert, könnte beispielsweise das durch die Prozessoren der Leistungsmodule erzeugte Signal zum Abschalten ausgesetzt werden. Dies könnte beispielsweise bei einer leistungselektronischen Schaltung für einen elektrischen Flugzeugantrieb kurz vor einer Notlandung der Fall sein, wobei ein Versagen des Leistungsmoduls nach der Notlandung hingenommen werden könnte.

Gemäß einer besondere Ausgestaltung der Erfindung kann vorgesehen werden, dass der zentrale Prozessor ein Steuersignal zum Abschalten desjenigen Leistungsmoduls erzeugt, dessen Zustandsdaten im Vergleich zu anderen parallel geschalteten Leistungsmodulen die höchste Belastung anzeigt. Dies ermöglicht vorteilhaft ein Betriebsverfahren, welches eine gleichmäßige Belastung aller Leistungsmodule der leistungselektronischen Schaltung ermöglicht. Ein Abschalten von Leistungsmodulen ist beispielsweise möglich, wenn der Betriebszustand gerade nicht unter Volllast erfolgt. Es ist damit vorteilhaft möglich, Leistungsmodule, welche aufgrund einer gewissen Streuung in der Qualität schneller überlastet sind (beispielsweise schneller erwärmen), zu schonen und dafür Leistungsmodule zu bevorzugen, welche eine bessere Qualität aufweisen. Insgesamt kann dadurch vorteilhaft die Lebensdauer der leistungselektronischen Schaltung verlängert werden.

Der zentrale Prozessor und/oder die Prozessoren der Leistungsmodule können vorteilhaft eine zeitliche Entwicklung der Zustandsdaten erfassen und daraus ein Alterungskriterium generieren. Hierdurch können beispielsweise Module mit einer geringeren Qualität rechtzeitig ausgewechselt werden, um ein Versagen der leistungselektronischen Schaltung zu verhindern. Besonders vorteilhaft kann dann durch den zentralen Prozessor und/oder die Prozessoren der Leistungsmodule in Abhängigkeit des Alterungskriteriums ein Wartungssignal zur Anzeige notwendiger Wartungsmaßnahmen generiert werden. Diese Wartungsmaßnahmen müssen nicht notwendigerweise in einem bevorstehenden Austausch von Leistungsmodulen bestehen. Auch andere Wartungsmaßnahmen können angezeigt werden. Beispielsweise kann eine Überhitzung von Leistungsmodulen auch darauf hinweisen, dass ein Kühlproblem besteht und insofern die Wartung des Kühlsystems initiiert werden muss.

Besonders vorteilhaft ist es, wenn in der mindestens einen Speichereinheit (des zentralen Prozessors oder der Prozessoren der Leistungsmodule) als Zustandsdaten auch Fertigungsdaten und/oder Prüfdaten der Leistungsmodule gespeichert werden. Hierdurch ist es vorteilhaft möglich, bereits während der Fertigung ermittelte Daten bei der Steuerung der leistungselektronischen Schaltung mit einzubeziehen. Es ist beispielsweises möglich, bei der Montage Leistungsmodule mit möglichst ähnlichen Eigenschaften zur leistungselektronischen Schaltung zu kombinieren, um ein möglichst homogenes elektrisches Verhalten der leistungselektronischen Schaltung zu erzeugen (sog. Binning). Auch während des Betriebs können bevorzugt Leistungsmodule mit ähnlichem elektrischem Verhalten zusammen geschaltet werden, solange es der Betriebszustand nicht erfordert, dass alle Leistungsmodule eingeschaltet werden.

Die oben genannte Aufgabe wird durch die eingangs angegebene leistungselektronische Schaltung erfindungsgemäß auch dadurch gelöst, dass jedes Leistungsmodul mindestens ein Sensorelement zur Erfassung einer Zustandsgröße des Leistungsmoduls aufweist und dass jedes Leistungsmodul eine Treiberschaltung für das mindestens eine leistungselektronische Bauelement aufweist. Außerdem ist erfindungsgemäß vorgesehen, dass die leistungselektronische Schaltung einen Prozessor mit einem Programm zur Erarbeitung von Sensorsignalen und zur Ausgabe von Steuersignalen aufweist. Der Prozessor ist mindestens einem Leistungsmodul zugeordnet, derart, dass dieser eine erste Schnittstelle für Sensorsignale zu dem mindestens einem Sensorelement zugeordneten Leistungsmodul und eine zweite Schnittstelle für Steuersignale zu der Treiberschaltung des zugeordneten Leistungsmoduls aufweist. Es können also, wie oben bereits erwähnt, ein zentraler Prozessor für die leistungselektronische Schaltung und/oder Prozessoren für Leistungsmodule zum Einsatz kommen. Als Sensorelemente können beispielsweise Temperatursensoren und/oder Stromsensoren und/oder Spannungssensoren und/oder Feuchtigkeitssensoren und/oder Beschleunigungssensoren zum Einsatz kommen.

Temperatursensoren kommen beispielsweise zum Einsatz, damit die Betriebstemperatur der Leistungsmodule überwacht werden kann. Dies ermöglicht beispielsweise ein rechtzeitiges Abschalten, um eine Überlastung oder Beschädigung des Leistungsmoduls zu verhindern. Ein Temperatursensor kann aber auch zum Einsatz kommen, um die Umgebungstemperatur der leistungselektronischen Schaltung zu bestimmen, und beispielsweise das voraussichtliche Kühlungsverhalten zu bestimmen.

Feuchtigkeitssensoren können verwendet werden, um die Betriebsbedingungen für die leistungselektronische Schaltung zu überwachen. Bei einer zu hohen Feuchtigkeit muss die leistungselektronische Schaltung getrocknet werden, bevor ein Betrieb oder Weiterbetrieb möglich ist. Eine zu hohe Feuchtigkeit kann beispielsweise bei niedrigen Außentemperaturen durch die Bildung von Tau entstehen. Eine andere Möglichkeit besteht darin, dass eine Wasserkühlung undicht geworden ist.

Stromsensoren kommen zum Einsatz, um den Betriebszustand der leistungselektronischen Schaltung zu überwachen. Beispielsweise kann die Strombelastung in den einzelnen Leistungsmodulen miteinander verglichen werden. Eine Strommessung kann beispielsweise auch für einen Betrieb einer Treiberschaltung für die Leistungsmodule erforderlich sein.

Das Sensorelement kann vorteilhaft auch als Beschleunigungssensor ausgebildet sein. Beschleunigungssensoren ermöglichen vorteilhaft die Ermittlung von mechanischen Beanspruchungen der leistungselektronischen Schaltung. Beispielsweise können Ereignisse aufgezeichnet werden, welche einen Weiterbetrieb der leistungselektronischen Schaltung ausschließen, bevor eine Wartung vorgenommen wurde, beispielsweise weil die leistungselektronische Schaltung bei einem mobilen Einsatz heruntergefallen ist. Beschleunigungssensoren können aber auch verwendet werden, um beispielsweise Vibrationen zu ermitteln. Abhängig von Häufigkeit und Stärke der Vibration können z. B. flexible Wartungsintervalle für die leistungselektronische Schaltung ausgegeben werden.

Gemäß vorteilhaften Ausgestaltungen der Erfindung kann vorgesehen werden, dass jedes Leistungsmodul einen Prozessor aufweist und/oder dass zusätzlich ein zentraler Prozessor vorgesehen ist, welcher eine dritte Schnittstelle zu den Prozessoren der Leistungsmodule aufweist. Die Vorteile dieser Maßnahmen sind im Zusammenhang mit dem oben genannten Verfahren bereits ausführlich erläutert worden.

Gemäß einer besonderen Ausgestaltung der Erfindung ist vorgesehen, dass für die leistungselektronische Schaltung eine Nennlast definiert ist, wobei die leistungselektronische Schaltung mehr parallel geschaltete Leistungsmodule aufweist, als für einen dauerhaften Betrieb bei Nennlast notwendig ist. Dies ermöglicht es im Normalbetrieb, also Betrieb bei Nennlast, dass nicht alle Leistungsmodule für den Betrieb erforderlich sind, so dass einzelne Leistungsmodule während des Betriebs bei Nennlast abgeschaltet werden können. Mit einer leistungselektronischen Schaltung dieser Art kann vorteilhaft ein oben bereits beschriebenes Verfahren zum Steuern der leistungselektronischen Schaltung zum Einsatz kommen, bei dem der zentrale Prozessor ein Steuersignal zum Abschalten von Leistungsmodulen erzeugt. Insbesondere kann der Prozessor dasjenige Leistungsmodul oder diejenigen Leistungsmodule abschalten, dessen oder deren Zustandsdaten im Vergleich zu anderen parallel geschalteten Leistungsmodulen die höchste Belastung anzeigt. Die Vorteile dieses Verfahrens sind bereits obenstehend erläutert worden.

Des Weiteren wird ein Computerprogrammprodukt mit Programmbefehlen zur Durchführung des genannten erfindungsgemäßen Verfahrens und/oder dessen Ausführungsbeispielen beansprucht, wobei mittels des Computerprogrammprodukts jeweils das erfindungsgemäße Verfahren und/oder dessen Ausführungsbeispiele durchführbar sind.

Darüber hinaus wird eine Bereitstellungsvorrichtung zum Speichern und/oder Bereitstellen des Computerprogrammprodukts beansprucht. Die Bereitstellungsvorrichtung ist beispielsweise ein Datenträger, der das Computerprogrammprodukt speichert und/oder bereitstellt. Alternativ und/oder zusätzlich ist die Bereitstellungsvorrichtung beispielsweise ein Netzwerkdienst, ein Computersystem, ein Serversystem, insbesondere ein verteiltes Computersystem, ein cloudbasiertes Rechnersystem und/oder virtuelles Rechnersystem, welches das Computerprogrammprodukt vorzugsweise in Form eines Datenstroms speichert und/oder bereitstellt.

Diese Bereitstellung erfolgt beispielsweise als Download in Form eines Programmdatenblocks und/oder Befehlsdatenblocks, vorzugsweise als Datei, insbesondere als Downloaddatei, oder als Datenstrom, insbesondere als Downloaddatenstrom, des vollständigen Computerprogrammprodukts. Diese Bereitstellung kann beispielsweise aber auch als partieller Download erfolgen, der aus mehreren Teilen besteht und insbesondere über ein Peer-to-Peer Netzwerk heruntergeladen oder als Datenstrom bereitgestellt wird. Ein solches Computerprogrammprodukt wird beispielsweise unter Verwendung der Bereitstellungsvorrichtung in Form des Datenträgers in ein System eingelesen und führt die Programmbefehle aus, sodass das erfindungsgemäße Verfahren auf einem Computer zur Ausführung gebracht wird oder das Erstellungsgerät derart konfiguriert, dass dieses das erfindungsgemäße Werkstück erzeugt. Weitere Einzelheiten der Erfindung werden nachfolgend anhand der Zeichnung beschrieben. Gleiche oder sich entsprechende Zeichnungselemente sind jeweils mit den gleichen Bezugszeichen versehen und werden nur insoweit mehrfach erläutert, wie sich Unterschiede zwischen den einzelnen Figuren ergeben.

Bei den im Folgenden erläuterten Ausführungsbeispielen handelt es sich um bevorzugte Ausführungsformen der Erfindung. Bei den Ausführungsbeispielen stellen die beschriebenen Komponenten der Ausführungsformen jeweils einzelne, unabhängig voneinander zu betrachtende Merkmale der Erfindung dar, welche die Erfindung jeweils auch unabhängig voneinander weiterbilden und damit auch einzeln oder in einer anderen als der gezeigten Kombination als Bestandteil der Erfindung anzusehen sind. Des Weiteren sind die beschriebenen Ausführungsformen auch durch weitere der bereits beschriebenen Merkmale der Erfindung ergänzbar.

Es zeigen:
- Figur 1: ein Leistungsmodul, wie es in einem Ausführungsbeispiel der leistungselektronischen Schaltung zum Einsatz kommen kann, in dreidimensionaler Ansicht, teilweise geschnitten,
- Figur 2: das Detail II gemäß Figur 1, teilweise aufgeschnitten,
- Figur 3: ein Ausführungsbeispiel der leistungselektronischen Schaltung mit einer Vielzahl von Leistungsmodulen, die gemäß Figur 1 oder ähnlich aufgebaut sein können, als Aufsicht,
- Figur 4: schematisch einen Schaltplan für die Kontaktierung von Leistungsmodulen gemäß Figur 1 in einer leistungselektronischen Schaltung gemäß Figur 3,
- Figur 5: ein Ausführungsbeispiel der leistungselektronischen Schaltung mit Prozessoren für die Leistungsmodule und einem zentralen Prozessor, als Blockschaltbild,
- Figur 6: ein anderes Ausführungsbeispiel der leistungselektronischen Schaltung mit einem Prozessor für mehrere Leistungsmodule als Blockschaltbild und
- Figur 7: ein Ausführungsbeispiel des erfindungsgemäßen Verfahrens bei Nennlast mit Abschaltung einzelner Leistungsmodule als Seitenansicht.

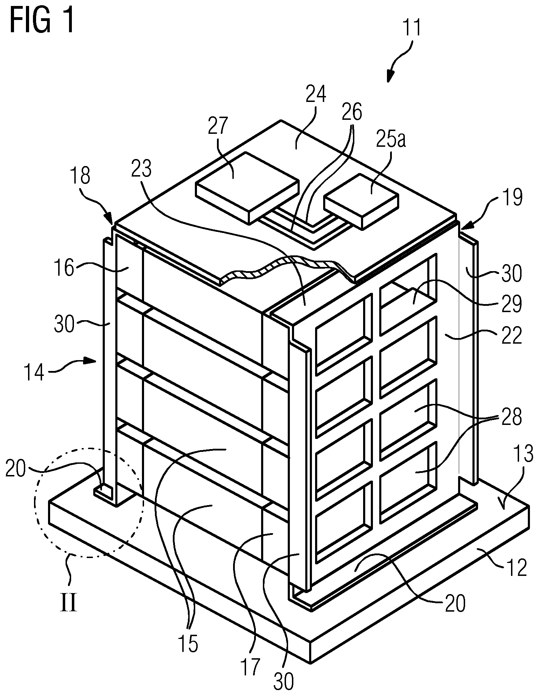

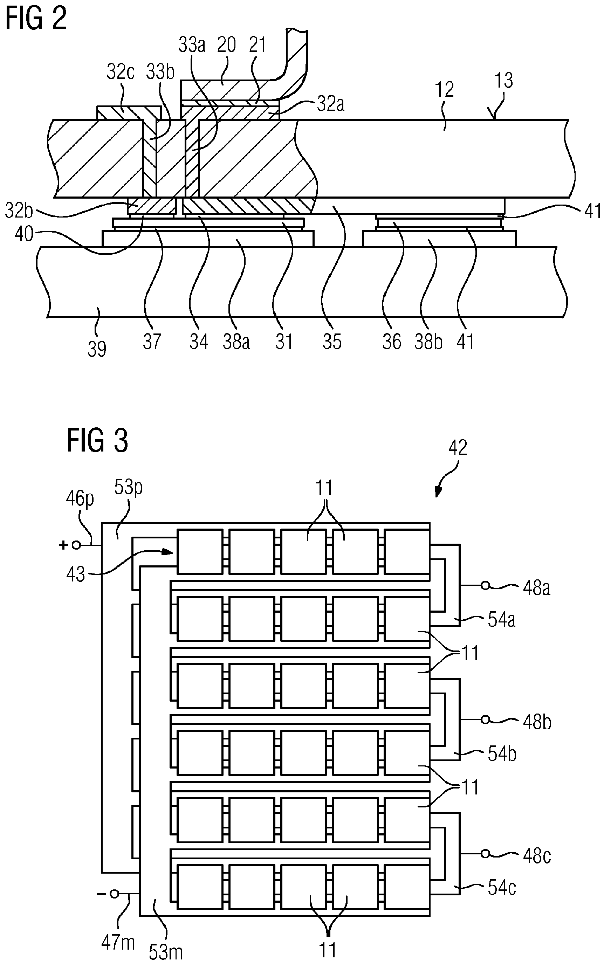

Ein Leistungsmodul 11 gemäß Figur 1 weist eine Substratplatte 12 auf, auf deren sichtbarer Oberseite 13 ein Kondensatoraufbau 14 nach einem Verfahren der Oberflächenmontage montiert wurde. Der Kondensatoraufbau weist acht Kondensatoren 15 auf, von denen in Figur 1 jedoch nur sieben dargestellt sind (der rechts oben angeordnete Kondensator fehlt; hierzu im Folgenden noch mehr). Die Kondensatoren 15 weisen jeweils erste Kondensatorelektroden 16 und zweite Kondensatorelektroden 17 auf, wobei die ersten Kondensatorelektroden 16 mit einer ersten Elektrode 18 und die zweiten Kondensatorelektroden 17 mit einer zweiten Elektrode 19 durch nicht näher dargestellte Blödverbindungen oder anderen stoff- oder formschlüssige Verbindungen elektrisch kontaktiert sind. Die erste Elektrode 18 und die zweite Elektrode 19 weisen überdies je eine Kontaktstruktur 20 auf, die mit ihren unteren Seiten an der ersten Elektrode eine erste Anschlussfläche und an der zweiten Elektrode eine zweite Anschlussfläche bilden (in Figur 1 nicht zu erkennen, da der Oberseite 13 zugewandt). Mit der ersten Anschlussfläche und der zweiten Anschlussfläche, die gemeinsam die Montageseite des Kondesatoraufbaus 14 ausbilden, ist dieser auf die Oberseite der Substratplatte 12 mittels einer nicht näher dargestellten Lötverbindung 21 (vgl. Figur 2) montiert.

Die erste Elektrode 18 und die zweite Elektrode 19 bilden gemeinsam eine Haltestruktur für die Kondensatoren 15 aus. Da die Kondensatoren 15 mit ihren ersten Kontaktelektroden 16 und ihren zweiten Kontaktelektroden 17 mit Seitenwänden 22 der ersten Elektrode 18 und zweiten Elektrode 19 verlötet sind, entsteht der selbsttragende Kondensatoraufbau 14, obwohl die erste Elektrode 18 und die zweite Elektrode 18 nicht direkt miteinander verbunden sind. Zusätzliche Stabilität erlangt der Kondensatoraufbau 11 durch Montage auf der Substratplatte 12. Außerdem ist auf Aufnahmestrukturen 23 der ersten Elektrode 18 und der zweiten Elektrode 19 ein Schaltungsträger 24 als zusätzliche Baustruktur befestigt, wobei der Schaltungsträger 24 eine Verbindung zwischen der ersten Elektrode 18 und der zweiten Elektrode 19 herstellt und damit die Haltestruktur stabilisiert.

In der Seitenwand 22 der ersten Elektrode 18 (nicht zu erkennen in Figur 1) und der zweiten Elektrode 19 sind Fenster 28 eingestanzt. Diese eröffnen die Möglichkeit, Zungen 29 in den Innenraum der Haltestruktur hinein zu biegen, die eine Positionierung der Kondensatoren 15 erleichtern und überdies die elektrische Kontaktfläche vergrößern. Da der rechts oben befindliche Kondensator hinter der Seitenwand 22 weggelassen wurde, kann die Zunge 29 dort dargestellt werden. In den anderen Fenstern sind die Zungen von den zweiten Kondensatorelektroden 17 verdeckt.

Auf dem Schaltungsträger 24 ist ein Sensorelement 25a befestigt, wobei es sich beispielsweise um einen Temperatursensor oder einen Beschleunigungssensor (oder Feuchtesensor oder Gassensor) handelt. Über Leiterbahnen 26 auf dem Schaltungsträger 24 ist das Sensorelement 25a mit einer Auswertungsschaltung in Form eines integrierten Schaltkreises 27 verbunden. Der integrierte Schaltkreis 27 kann das Sensorsignal auswerten und in nicht näher dargestellter Weise für eine Weiterverarbeitung zur Verfügung stellen (beispielsweise über nicht dargestellte Leitungsverbindungen oder eine schnurlose Schnittstelle, also über Funk oder Infrarot).

Als weitere Baustruktur sind an den Seitenkanten der Seitenwand 22 Rippen 30 als Versteifungsstruktur hergestellt. Diese können durch Umbiegen der Seitenkanten der Seitenwände 22 erzeugt werden. Die erste Elektrode 18 und die zweite Elektrode 19 können somit kostengünstig als Leadframe durch Stanzen und anschließendes Biegen erzeugt werden. Durch Biegen können auch jeweils die Aufnahmestrukturen 23 und die Kontaktstrukturen 20 hergestellt werden.

In Figur 2 ist dargestellt, wie eine Kontaktierung der Kondensatoranordnung 14 gemäß Figur 1 mit einem als Transistor ausgeführten leistungselektronischen Bauelement 31 erfolgen kann. Zu diesem Zweck ist die Kontaktstruktur 20 über die Lötverbindung 21 mit einem Kontaktpad 32a kontaktiert, wobei das Kontaktpad 32a über eine Durchkontaktierung 33a mit einer Sourceelektrode 34 des leistungselektronischen Bauelements 31 kontaktiert ist. Die Sourceelektrode 34 ist außerdem über eine Leiterbahn 35 mit einem Distanzstück 36 verbunden, welches dieselbe Höhe wie das leistungselektronische Bauelement 31 aufweist.

Eine Drainelektrode 37 des leistungselektronischen Bauelements 31 ist über eine Kontaktfläche 38a und das Distanzstück 36 ist über eine Kontaktfläche 38b mit einem Basisschaltungsträger 39 verbunden. Der Basisschaltungsträger 39 stellt eine Grundplatte zur Verfügung, auf der die ganze elektronische Schaltung, bestehend aus mehreren Leistungsmodulen gemäß Figur 1, montiert ist (vgl. auch Figur 3).

Bei dem leistungselektronischen Bauelement gemäß Figur 2 handelt es sich um einen Transistor. Damit dieser geschaltet werden kann, ist weiterhin eine Gateelektrode 40 notwendig. Damit diese angesteuert werden kann, ist in der Substratplatte 12 eine Durchkontaktierung 33b vorgesehen, die von einem Kontaktpad 32b zu einem Kontaktpad 32c führt. Sourceelektrode 34, Gateelektrode 40, Drainelektrode 37 sowie Fügeschichten 41 am Distanzstück 36 sind als Sinterverbindungen ausgebildet.

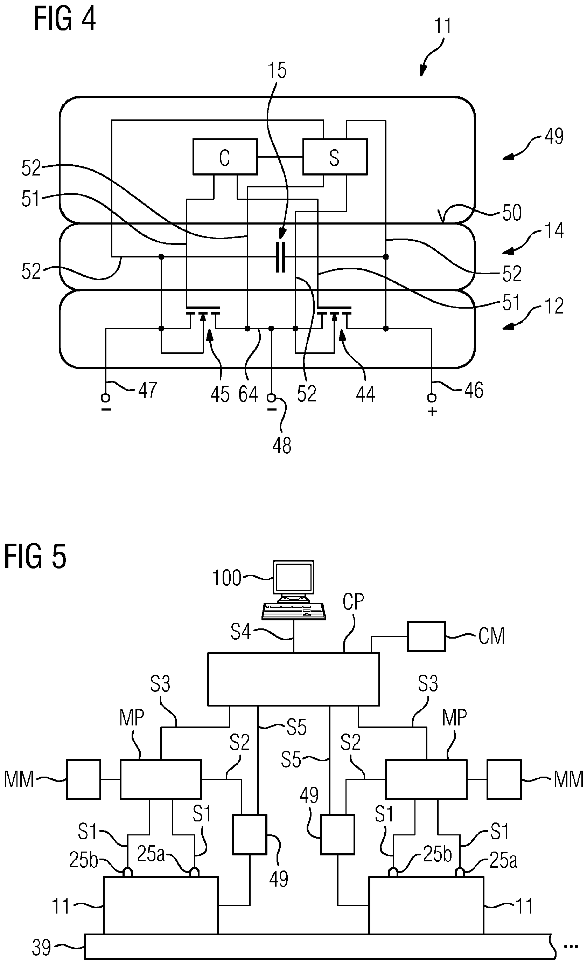

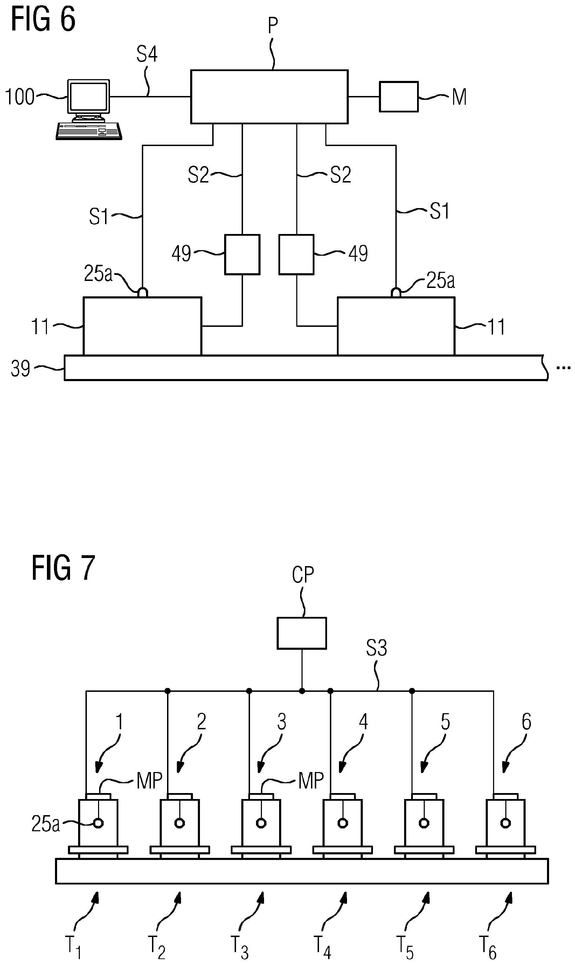

In Figur 3 ist dargestellt, wie mehrere Leistungsmodule 11 auf einem Basisschaltungsträger 39 gemäß Figur 2 zu einer leistungselektronischen Schaltung 42 kombiniert werden können. Fünf Leistungsmodule 11 sind jeweils zu einer Reihe 43 konfiguriert, wobei insgesamt sechs Reihen vorgesehen sind. Wie Figur 2 zu entnehmen ist, ist von der Substratplatte 12 nur die linke Seite dargestellt, wobei die rechte Seite ein weiteres leistungelektronisches Bauelement 31 aufweist (wie in Figur 6 dargestellt). Dies bedeutet, dass auf der nicht dargestellten Seite der Substratplatte gemäß Figur 2 ebenfalls ein Transistor als leistungselektronisches Bauelement verbaut ist. Hieraus ergibt sich eine Kontaktierungsmöglichkeit, die in Figur 3 für jedes Leistungsmodul 11 realisiert ist und in Figur 4 schematisch als Schaltbild dargestellt ist.

In Figur 4 ist der Kondensator 15 als Ersatz für den gesamten Kondensatoraufbau gemäß Figur 1 dargestellt. Dies dient der Vereinfachung der Darstellung, wobei alternativ auch eine Vielzahl parallel geschalteter Kondensatoren zum Einsatz kommen kann. Der Kondensator 15 gemäß Figur 4 wie auch der Kondensatoraufbau 14 ist lediglich schematisch dargestellt. Genauso verhält es sich mit der Substratplatte 12 und den darauf montierten leistungselektronischen Bauelementen, die durch einen ersten Transistor 44 und einen zweiten Transistor 45 ausgebildet sind. Der erste Transistor 44 ist mit seiner Source-Elektrode an den auch als High-Side bezeichneten Pluspol 46 angeschlossen, während der zweite Transistor 45 mit seiner Drain-Elektrode an den auch als Low-Side bezeichneten Minuspol 47 angeschlossen ist. Die Drain-Elektrode des ersten Transistors 44 ist mit der Source-Elektrode des zweiten Transistors 45 sind miteinander verbunden, wobei hierdurch eine Halbbrücke 64 mit einem Phasenkontakt 48 entsteht.

Zur Ansteuerung des Leistungsmoduls 11 ist der Kondensatoraufbau 14 mit einer Treiberschaltung 49 versehen, die gemäß Figur 5 beispielsweise auf einer Oberseite 50 des Kondensatoraufbaus 14 untergebracht sein kann.

Die Treiberschaltung gemäß Figur 4 ist nur schematisch dargestellt, um deren Funktion im Grundsatz zu beschreiben. Die Treiberschaltung weist eine Controllerfunktion C auf sowie eine Sensorfunktion S. Die Controllerfunktion wird durch Kontaktleitungen 51 als Schnittstelle zu den Gate-Elektroden des ersten Transistors 44 und des zweiten Transistors 45 gewährleistet. Damit kann die Treiberschaltung beide Transistoren als Schalter intelligenter ansteuern. Die für diese Funktion notwendigen Informationen werden durch die Sensorfunktion S zur Verfügung gestellt. Die Sensorfunktion wird über Signalleitungen 52 gewährleistet, mit denen ein Stromfluss vor und hinter dem Kondensator 15 sowie vor und hinter dem Phasenkontakt 48 in der Halbbrücke 64 abgegriffen werden kann.

Der Kondensator 15 ist mit dem Pluspol 46 und dem Minuspol 47 verbunden und erfüllt damit eine Glättungsfunktion, die für einen mehrphasigen Betrieb der leistungselektronischen Schaltung 42 gemäß Figur 3 erforderlich ist.

Wie in Figur 3 zu erkennen ist, ist die leistungselektronische Schaltung 42 gemäß Figur 3 modular aufgebaut. Mittels der durch die Leistungsmodule 11 gemäß Figur 4 realisierten Schaltung können diese in drei Gruppen jeweils gemeinsam verwendet werden, um aus einer am gemeinsamen Pluspol 46p und am gemeinsamen Minuspol 47m anliegenden Gleichspannung eine dreiphasige Wechselspannung zu erzeugen, die an den gemeinsamen Phasenkontakten 48a, 48b, 48c abgegriffen werden kann. Die Höhe des zu schaltenden maximalen Stroms bestimmt, wie viele der Leistungsmodule 11 pro Phase zum Einsatz kommen müssen. Gemäß Figur 3 handelt es sich um jeweils zehn Leistungsmodule 11 pro Phase.

Wie zu erkennen ist, sind die Elektroden 53m, 53p des Pluspols 46p und des Minuspols 47m kammartig ausgebildet, so dass jeweils durch die den Pluspol 46p bildende Elektrode 53p jeder erste Transistor 44 jedes Leistungsmoduls 11 und mit der den Minuspol 53m Elektrode 53m jeder zweite Transistor 45 jedes Leistungsmoduls 11 kontaktiert werden kann. Die Phasenkontakte 48a, 48b, 48c sind jeweils mit U-förmigen Elektroden 54a, 54b, 54c verbunden, welche jeweils im mittleren Bereich der Leistungsmodule 11 sowohl den ersten Kondensator 44 als auch den zweiten Kondensator 45 kontaktieren und auf diese Weise jeweils eine der drei Gruppen von je zehn Leistungsmodulen 11 über eine Halbbrücke (64 in Figur 4) kontaktieren. Damit ist für jedes der Leistungsmodule 11 eine Schaltung gemäß Figur 4 realisiert, wobei jede Gruppe von Leistungsmodulen 11 parallel geschaltet ist.

In Figur 5 und 6 sind leistungselektronische Schaltungen dargestellt, die beispielsweise gemäß Figur 3 aufgebaut sein können. Allerdings sind nur jeweils zwei Leistungsmodule 11 dargestellt. Weitere nicht dargestellte können aber in gleicher Weise angesteuert werden. Die Treiberschaltungen 49 können wie in Figur 4 gezeigt ausgeführt sein. Eine Sensorik S ist hier jedoch nicht näher dargestellt, kann jedoch entsprechend ausgeführt sein.

Bei der leistungselektronischen Schaltung gemäß Figur 5 weist jedes Leistungsmodul 11 ein Sensorelement 25a, z. B. einen Temperatursensor, und ein Sensorelement 25b, z. B. einen Feuchtigkeitssensor, auf. Diese Sensoren werden über erste Schnittstellen S1 mit Prozessoren MP verbunden, wobei jedes der Leistungsmodule 11 einen eigenen Prozessor MP aufweist.

Die Prozessoren MP sind zur Speicherung eines Programms geeignet, welches auf den Prozessoren MP abläuft und eine Datenverarbeitung ermöglicht, damit aus den durch die Sensorelemente 25a, 25b ermittelten Zustandsgrößen (hier Temperatur und Feuchtigkeit) Zustandsdaten berechnet werden können. Diese Zustandsdaten können in einer Speichereinheit MM abgelegt werden, welche in Figur 5 als getrennter Baustein dargestellt ist, jedoch auch integraler Bestandteil des Prozessors MP sein kann (dies gilt auch für die im Folgenden noch näher erläuterten Speichereinheiten CM für den zentralen Prozessor CP und Speichereinheiten M für den Prozessor P).

Das Programm, welches in den Prozessoren MP abläuft, erzeugt außerdem Steuersignale, welche über Schnittstellen S2 an die Treiberschaltungen 49 weitergegeben werden können. Die Treiberschaltungen 49 regeln ihrerseits in der bereits beschriebenen Weise die Funktion der Leistungsmodule 11 in Abhängigkeit von den über die Schnittstellen S2 empfangenen Steuersignalen. Die Steuersignale können beispielsweise Steuerbefehle enthalten, die ein Einschalten oder Abschalten der Leistungsmodule betreffen. Es ist auch möglich, über die Schnittstellen S2 ein Steuersignal hinsichtlich der Leistungsabgabe durch die Leistungsmodule 11 weiter zu geben.

Außerdem sind die Prozessoren MP über eine Schnittstelle S3 mit einem zentralen Prozessor CP verbunden. Dieser Prozessor CP kann von den Prozessoren der Leistungsmodule MP bestimmte Daten erhalten, die zur Beurteilung des Betriebszustands der leistungselektronischen Schaltung insgesamt erforderlich sind. Beispielsweise können diese Daten in einem drohenden Versagen eines der Leistungsmodule bestehen, so dass über den zentralen Prozessor, auf dem ebenfalls ein Programm abläuft, bestimmte Leistungsmodule zu- oder abgeschaltet werden können oder deren Leistung gedrosselt werden kann. Auch der zentrale Prozessor CP hat eine Speichereinheit CM.

Auf den Speichereinheiten MM, CM können Daten gespeichert werden, die die Historie des Betriebs der leistungselektronischen Schaltung betreffen. Diese Daten können ausgewertet werden, um beispielsweise Wartungsintervalle zu definieren oder das drohende Versagen der leistungselektronischen Schaltung anzuzeigen. Zu diesem Zweck kann an den zentralen Prozessor CP eine Ausgabeeinheit wie beispielsweise ein Computer 100 angeschlossen werden. Es ist auch möglich, dass über die Schnittstelle S4 ein einfacheres Ausgabegerät, wie beispielsweise ein Display oder eine Leuchtdiode, angeschlossen wird. Auch kann das Ausgabegerät integraler Bestandteil der baulichen Einheit sein, die den zentralen Prozessor enthält (nicht näher dargestellt).

Der zentrale Prozessor CP kann überdies ebenfalls auf die Treiberschaltungen 49 für die Leistungsmodule 11 zugreifen. Hierfür ist die Schnittstelle S5 vorgesehen. Hierdurch ist es möglich, dass sowohl die Prozessoren der Leistungsmodule MP als auch der zentrale Prozessor CP die Steuerung der Leistungsmodule 11 übernehmen kann. Auf den Prozessoren der Leistungsmodule MP und dem zentralen Prozessor laufen jeweils Programme, die Steuersignale mit unterschiedlicher Priorität abgeben können, so dass je nach Priorität der zentrale Prozessor CP oder die Prozessoren der Leistungsmodule MP die Steuerung übernehmen. Eine Koordination der Steuerung kann über die Schnittstelle S3 zwischen dem zentralen Prozessor CP und den Prozessoren der Leistungsmodule MP erfolgen.

Gemäß Figur 6 ist eine im Vergleich zu derjenigen gemäß Figur 5 vereinfachte Steuerung dargestellt. Diese weist nur einen Prozessor P auf, der für alle Leistungsmodule 11 verantwortlich ist. Dieser weist daher die Schnittstelle S2 zu den Treiberschaltungen 49 auf und wird über die Schnittstellen S1 mit den Sensorsignalen der Sensorelemente 25a versorgt. Gleichzeitig weist der Prozessor P die Schnittstelle S4 für ein Ausgabegerät in Form des Computers 100 auf. In der Speichereinheit M können Zustandsdaten abgelegt werden, die der Prozessor P aus den Sensordaten der Sensorelemente 25a berechnet hat.

In Figur 7 ist eine leistungselektronische Schaltung mit sechs Leistungsmodulen 1, 2, 3, 4, 5, 6 dargestellt. Diese weisen alle je ein Sensorelement 25a auf, wobei jedes Leistungsmodul einen Prozessor MP zur Verarbeitung der Sensordaten besitzt. Die Prozessoren MP sind über ein Bussystem, welches die Schnittstelle S3 bildet, mit dem zentralen Prozessor CP verbunden.

Für den Betrieb unter Nennlast sind nur vier der Leistungsmodule notwendig. Deswegen steuert der zentrale Prozessor CP nur die Prozessoren MP der Leistungsmodule 1 bis 4 an, damit diese die zugehörigen Leistungsmodule aktivieren. Während des werden die Temperaturen T₁ bis T₆ überwacht, wobei sich in dem Ausführungsbeispiel gemäß Figur 7 die Temperatur T₄ des Leistungsmoduls 4 schneller erhöht, als T₁ bis T₃. Über die dritte Schnittstelle S3 gibt der zugehörige Prozessor MP zuerst das Überschreiten einer zulässigen Temperatur des Leistungsmoduls an den zentralen Prozessor CP weiter (Datenverdichtung). Dieser veranlasst den Prozessor MP des Leistungsmoduls 4, dieses abzuschalten. Gleichzeitig bekommt der Prozessor des Leistungsmoduls 5 den Befehl, dieses in Betrieb zu nehmen.

Bei späteren Umschaltvorgängen in der oben beschriebenen Weise fragt der zentrale Prozessor CP die Temperaturen der jeweiligen Leistungsmodule (im Beispiel also als nächstes T₄ und T₆) ab, welche gerade nicht in Betrieb sind und schaltet jeweils dasjenige Leistungsmodul zu, welches von diesen Leistungsmodulen die geringste Temperatur aufweist. Dies bewirkt, dass Leistungsmodule, die eine bestimmte Temperatur überschritten haben, immer möglichste lange abgeschaltet bleiben, um möglichst weit abzukühlen.

## Patentansprüche

1. Verfahren zum Steuern einer leistungselektronischen Schaltung (42), bei der eine Vielzahl von Leistungsmodulen (11), die jeweils mindestens ein leistungselektronisches Bauelement (31) aufweisen, angesteuert wird,
**dadurch gekennzeichnet,**
**dass**
• jedes Leistungsmodul (11) mit einer eigenen Treiberschaltung (49) separat angesteuert wird,
• von jedem Leistungsmodul (11) mit einem eigenen Sensorelement (25a, 25b) zumindest eine Zustandsgröße erfasst wird,
• die Treiberschaltung (49) jedes Leistungsmoduls (11) mit einem Prozessor (P, CP, MP), der aus der Zustandsgröße Zustandsdaten berechnet, in Abhängigkeit von den Zustandsdaten gesteuert wird.

2. Verfahren nach Anspruch 1,
**dadurch gekennzeichnet,**
**dass** jedes Leistungsmodul (11) einen eigenen Prozessor (MP) aufweist, mit dem nur die Treiberschaltung dieses Leistungsmoduls (11) in Abhängigkeit von den Zustandsdaten gesteuert wird.

3. Verfahren nach Anspruch 2,
**dadurch gekennzeichnet,**
**dass** die leistungselektronische Schaltung (42) einen zentralen Prozessor (CP) aufweist, der mit den Prozessoren (MP) der Leistungsmodule (11) kommuniziert, derart, dass
• die Prozessoren (MP) der Leistungsmodule (11) Zustandsdaten der Leistungsmodule (11) an den zentralen Prozessor (CP) übergeben,
• der zentrale Prozessor (CP) Steuersignale für die Leistungsmodule (11) an die Prozessoren (MP) der Leistungsmodule (11) übergibt.

4. Verfahren nach einem der voranstehenden Ansprüche,
**dadurch gekennzeichnet,**
**dass** die Zustandsdaten der Leistungsmodule (11) einen berechneten Belastungszustand des jeweiligen Leistungsmoduls (11) enthalten.

5. Verfahren nach einem der voranstehenden Ansprüche,
**dadurch gekennzeichnet,**
**dass** Zustandsdaten der Leistungsmodule (11) in mindestens einer Speichereinheit (M, MM, CM) gespeichert werden.

6. Verfahren nach Anspruch 5,
**dadurch gekennzeichnet,**
**dass** jedem der Prozessoren (MP) der Leistungsmodule (11) jeweils eine Speichereinheit (M, MM, CM) für die Zustandsdaten zugeordnet ist.

7. Verfahren nach Anspruch 5 oder 6,
**dadurch gekennzeichnet,**
**dass** eine Speichereinheit (MM) für die Zustandsdaten dem zentralen Prozessor (CP) zugeordnet ist.

8. Verfahren nach einem der auf Anspruch 3 rückbezogenen Ansprüche 4 bis 7,
**dadurch gekennzeichnet,**
**dass** die Prozessoren (MP) der Leistungsmodule (11) die Zustandsdaten bewerten und nur eine Auswahl von Zustandsdaten an den zentralen Prozessor (CP) weitergeben.

9. Verfahren nach einem der voranstehenden Ansprüche,
**dadurch gekennzeichnet,**
**dass** die Prozessoren (MP) der Leistungsmodule (11) ein Steuersignal zum Abschalten des zugeordneten Leistungsmoduls (11) erzeugen, wenn die Zustandsdaten eine Überlastung, eine Beschädigung oder ein Versagen dieses Leistungsmoduls (11) anzeigen.

10. Verfahren nach einem der voranstehenden Ansprüche,
**dadurch gekennzeichnet,**
**dass** der zentrale Prozessor (CP) ein Steuersignal zum Abschalten desjenigen Leistungsmoduls (11) erzeugt, dessen Zustandsdaten im Vergleich zu anderen parallel geschalteten Leistungsmodulen (11) die höchste Belastung anzeigt.

11. Verfahren nach einem der voranstehenden Ansprüche,
**dadurch gekennzeichnet,**
**dass** der zentrale Prozessor (CP) und/oder die Prozessoren (MP) der Leistungsmodule (11) eine zeitliche Entwicklung von Zustandsdaten erfassen und daraus ein Alterungskriterium generieren.

12. Verfahren nach Anspruch 11,
**dadurch gekennzeichnet,**
**dass** durch den zentralen Prozessor (CP) und/oder die Prozessoren (MP) der Leistungsmodule (11) in Abhängigkeit des Alterungskriteriums ein Wartungssignal zur Anzeige notwendiger Wartungsmaßnahmen generiert wird.

13. Verfahren nach einem der Ansprüche 5 bis 12,
**dadurch gekennzeichnet,**
**dass** in der mindestens einen Speichereinheit (M, MM, CM) als Zustandsdaten Fertigungsdaten und/oder Prüfdaten der Leistungsmodule (11) gespeichert werden.

14. Leistungselektronische Schaltung (42) mit einer Vielzahl von Leistungsmodulen (11), wobei jedes Leistungsmodul (11) mindestens ein leistungselektronisches Bauelement (31) aufweist,
**dadurch gekennzeichnet,**
**dass**
• jedes Leistungsmodul (11) mindestens ein Sensorelement (25a) zur Erfassung einer Zustandsgröße des Leistungsmoduls (11) aufweist,
• jedes Leistungsmodul (11) eine Treiberschaltung (49) für das mindestens eine leistungselektronische Bauelement (31) aufweist,
• die leistungselektronische Schaltung (42) einen Prozessor (P, CP, MP) mit einem Programm zur Verarbeitung von Sensorsignalen und zur Ausgabe von Steuersignalen aufweist, wobei der Prozessor (P, CP, MP) mindestens einem Leistungsmodul (11) zugeordnet ist, derart, dass dieser eine erste Schnittstelle (S1) für Sensorsignale zu dem mindestens einen Sensorelement (11) des zugeordneten Leistungsmoduls (11) und eine zweite Schnittstelle (S2) für Steuersignale zu der Treiberschaltung (49) des zugeordneten Leistungsmoduls (11) aufweist.

15. Leistungselektronische Schaltung nach Anspruch 14,
**dadurch gekennzeichnet,**
**dass** jedes Leistungsmodul (11) einen Prozessor (MP) aufweist.

16. Leistungselektronische Schaltung nach Anspruch 15,
**dadurch gekennzeichnet,**
**dass** zusätzlich ein zentraler Prozessor (CP) vorgesehen ist, welcher eine dritte Schnittstelle (S3) zu den Prozessoren der Leistungsmodule (11) aufweist.

17. Leistungselektronische Schaltung nach einem der Ansprüche 14 bis 16,
**dadurch gekennzeichnet,**
**dass** für die leistungselektronische Schaltung (42) eine Nennlast definiert ist, wobei die leistungselektronische Schaltung (42) mehr parallel geschaltete Leistungsmodule (11) aufweist, als für einen dauerhaften Betrieb bei Nennlast notwendig ist.

18. Computerprogrammprodukt mit Programmbefehlen zur Durchführung des Verfahrens nach einem der Ansprüche 1 bis 13.

19. Bereitstellungsvorrichtung für das Computerprogrammprodukt nach Anspruch 18, wobei die Bereitstellungsvorrichtung das Computerprogrammprodukt speichert und/oder bereitstellt.
